# FASCICULE DE BREVET EUROPEEN

(11) **EP 2 499 281 B1**
(45) Date de publication et mention de la délivrance du brevet: **23.10.2013**
(21) Numéro de dépôt: 10787503.1
(22) Date de dépôt: 03.11.2010
(51) Int. Cl.: C25D 13/04, H01L 21/768, H01L 21/285

(54) **DEPOT SELECTIF DE NANOPARTICULES**
SELEKTIVE NANOPARTIKELABSCHEIDUNG
SELECTIVE NANOPARTICLE DEPOSITION

(30) Priorité: 10.11.2009 FR 0905392
(43) Date de publication de la demande: 19.09.2012
(73) Titulaire: Commissariat à l'Énergie Atomique et aux Énergies Alternatives, 75015 Paris (FR)
(72) Inventeur: DIJON, Jean, F-38800 Champagnier (FR); JOYEUX, Xavier, F-92270 Bois-Colombes (FR); PINSON, Jean, F-94120 Fontenay-sous-Bois (FR)
(74) Mandataire: Noel, Chantal Odile
(86) Numéro de dépôt international: PCT/FR2010/000731
(87) Numéro de publication internationale: WO 2011/058238

(56) Documents cités:
- US-A1- 2008 226 895
- X. JOYEUX, P. MANGIAGALLI, J. PINSON: "Localized attachment of carbon nanotubes in microelectronic structures", ADVANCED MATERIALS, vol. 21, 2 juin 2009 (2009-06-02), pages 4404-4408, XP002586720,
- CRUICKSHANK A C ET AL: "Electrochemical stability of citrate-capped gold nanoparticles electrostatically assembled on amine-modified glassy carbon", ELECTROCHIMICA ACTA, ELSEVIER SCIENCE PUBLISHERS, BARKING, GB LNKD- DOI:10.1016/J.ELECTACTA.2009.04.060, vol. 54, no. 23, 30 septembre 2009 (2009-09-30), pages 5566-5570, XP026236240, ISSN: 0013-4686 [extrait le 2009-05-03]
- J. A. HARNISCH, A. D. PRIS, M. D. PORTER: "Attachment of Gold Nanoparticles to Glassy Carbon Electrodes via a Mercaptobenzene Film", JOURNAL OF THE AMERICAN CHEMICAL SOCIETY, vol. 123, 25 mai 2001 (2001-05-25), pages 5829-5830, XP002586721,
- LEDAIN S ET AL: "An evaluation of electrografted copper seed layers for enhanced metallization of deep TSV structures", INTERCONNECT TECHNOLOGY CONFERENCE, 2008. IITC 2008. INTERNATIONAL, IEEE, PISCATAWAY, NJ, USA, 1 juin 2008 (2008-06-01), pages 159-161, XP031274527, ISBN: 987-1-4244-1911-1
- Paolo Manglagalli: "A Novel Approach to TSV Metallization based on Electrografted Copper Nucleation Layers", , 6 septembre 2007 (2007-09-06), XP002587454, Extrait de l'Internet: URL:https://electronics.wesrch.com/User_im ages/Pdf/EL17KLK_1196292818_4.pdf [extrait le 2010-06-14]
- TOH-MING LU AND GREGORY TEN EYCK: "Choices for future interconnect materials and processing", SOLID-STATE AND INTEGRATED CIRCUIT TECHNOLOGY, 2006. ICSICT '06. 8TH INTERNATIONAL CONFERENCE ON, octobre 2006 (2006-10), pages 287-290, XP002586722,

## Description

L'invention concerne un procédé de dépôt de nanoparticules en un matériau isolant, semi-conducteur ou conducteur sur des zones déterminées, en un matériau conducteur ou semi-conducteur, d'un substrat.

Elle concerne également un procédé de fabrication de nanotubes de carbone ainsi qu'un procédé de fabrication d'électrodes.

Dans un grand nombre d'applications mettant en oeuvre des nanotubes de carbone, il est nécessaire de localiser un catalyseur dans des structures de petites dimensions comme par exemple des vias afin de réaliser des interconnexions de faibles diamètres.

Il s'agit dans ce cas de nanoparticules de catalyseur, c'est-à-dire de particules ayant leur plus grande dimension inférieure ou égale à environ 100 nm.

Par ailleurs, une fois le catalyseur localisé dans le trou, il est nécessaire que le procédé de croissance de nanotubes de carbone puisse s'appliquer dans le trou.

Aujourd'hui plusieurs techniques sont utilisées pour déposer le catalyseur, ou toute autre nanoparticule, sans localisation sélective entre la couche supérieure et le fond des vias, par exemple.

Dans ces cas, les nanoparticules sont déposées sur toute la surface et sont ensuite enlevées par polissage mécanochimique "Chemical Mechanical Polishing" (CMP) ou par érosion ionique de la couche supérieure pour ne rester localisées que dans le fond de vias. Le procédé de dépôt doit être directif pour éviter le dépôt des nanoparticules et la croissance des nanotubes de carbone sur les flancs des trous.

Par ailleurs une des difficultés majeures est d'obtenir des particules de petite dimension, inférieures à 50 nm, stables jusqu'à une température d'environ 1000°C et en densité suffisante pour obtenir de fortes densités de nanotubes de carbone (entre 10¹¹ et 10¹⁴ nanotubes de carbone par cm²).

De nombreux procédés de dépôt de catalyseur sont décrits dans la littérature qui sont divisés en deux grandes classes : les procédés de dépôt d'un film mince et les procédés de dépôt direct de nanoparticules.

Avec les procédés de dépôt d'un film mince, l'épaisseur du film contrôle la taille moyenne, c'est-à-dire la moyenne statistique des tailles des particules, mesurée par microscopie électronique à balayage ou à transmission et calcul statistique et la densité des particules. Cependant, le contrôle de la taille et de la densité des particules ne peut s'effectuer de façon indépendante l'un de l'autre.

Le dépôt doit être recuit pour obtenir les nanoparticules par démouillage du film. La sélectivité du dépôt sur les zones voulues est obtenue par la combinaison de dépôts non conformes et de gravure.

Dans cette catégorie on trouve les dépôts PVD (Physical Vapor Deposition), les dépôts obtenus par voie chimique à partir d'une solution, par réduction de sels métalliques, par décomposition d'un sel métallique ou d'une protéine de stockage du fer (ferritine). Dans ce cas il n'y a aucune sélectivité du dépôt voire une difficulté à déposer le catalyseur en fond de trou à cause de problèmes de diffusion de ce dernier.

On trouve également les dépôts électrochimiques de films minces sur des conducteurs, dans cette catégorie de procédés.

Dans les procédés de dépôts directs de nanoparticules, les nanoparticules sont produites soit au moment de la réalisation du dépôt par décomposition laser d'un sel du catalyseur, par exemple du fer pentacarbonyle, par plasma, par utilisation de l'ablation laser d'une cible sous vide ou enfin par génération d'aérosol introduit directement dans un réacteur à flux laminaire, soit les nanoparticules sont produites avec un premier procédé puis mises en solution et le dépôt se fait par la suite sur les surfaces.

Dans ce cas il n'y a aucune sélectivité du dépôt par rapport à la structure sur laquelle il est effectué. Par contre on peut utiliser toutes les ressources de la chimie pour obtenir des nanoparticules bien calibrées en diamètre donc avec des distributions de tailles très étroites (écart type de l'ordre de 0,2 nm).

Or, dans un grand nombre d'applications, il est nécessaire de procéder à un dépôt sélectif de nanoparticles dans des dispositifs de petites dimensions.

En général, ces nanoparticules sont des nanoparticules de catalyseur.

En particulier, dans un grand nombre d'applications mettant en oeuvre des nanotubes de carbone, il est nécessaire de localiser un catalyseur dans des structures de petites dimensions, de l'ordre de 100 nm ou moins, comme par exemple des vias afin de réaliser des interconnexions de faible diamètre.

La croissance des nanotubes de carbone s'effectue à partir des nanoparticules de catalyseur.

Par "nanoparticules", on entend dans l'invention, des particules de diamètre moyen très faible, inférieur à 10 nm, de préférence compris entre 2 et 4 nm.

Dans le cas de la croissance de nanotubes de carbone, il est de plus nécessaire qu'une fois le catalyseur localisé dans le trou, le procédé de croissance des nanotubes de carbone puisse s'appliquer dans le trou.

Les caractéristiques idéales du dépôt de nanoparticules, en particulier de catalyseurs adaptés à cette application sont les suivantes :
- particules de diamètre très faible (nanoparticules),
- particules stables en température (pour éviter la coalescence et le frittage des particules individuelles). Pour cela, on préfère utiliser des particules à base d'oxydes métalliques plutôt que des particules ou couches métalliques,
- dépôt sélectif entre les surfaces horizontales et verticales de vias,
- dépôt sélectif entre les surfaces du haut ét du bas du substrat dans lequel se trouvent les vias, et
- contrôle de la distribution des particules (diamètre Phi, densité D et écart type sigma).

Le dépôt de films continus par PVD permet de déposer des particules de catalyseurs métalliques ou d'oxydes métalliques avec un dépôt sélectif entre les surfaces horizontales et verticales.

Il permet également le contrôle du diamètre des particules.

Cependant, il ne permet pas un dépôt sélectif entre les surfaces du haut et du bas.

Il ne permet pas non plus le contrôle de la densité des particules et de l'écart type sigma.

Le dépôt de films continus de particules par dépôt électrochimique permet le dépôt de catalyseurs métalliques avec un dépôt sélectif entre les surfaces horizontales et verticales ainsi qu'entre les surfaces du haut et du bas.

Il permet également le contrôle du diamètre des particules.

Mais il ne permet pas le dépôt d'un catalyseur oxyde métallique, qui est isolant, et il ne permet pas le contrôle indépendant de la densité des particules de la taille et de l'écart type sigma.

Le dépôt chimique en solution de films continus de particules permet le dépôt de catalyseurs métalliques, de catalyseurs oxydes métalliques et le contrôle du diamètre des particules.

Mais il ne permet pas un dépôt sélectif entre les surfaces horizontales et verticales et entre les surfaces du haut et du bas et ne permet pas de contrôler indépendamment la densité des particules, la taille et l'écart type.

Le dépôt PVD de nanoparticules permet le dépôt de catalyseurs métalliques et de catalyseurs oxydes métalliques.

II permet également le contrôle du diamètre des particules, de leurs densités et de l'écart type sigma.

Mais il ne permet pas un dépôt sélectif entre les surfaces du haut et du bas.

Ainsi, aucun procédé actuel ne satisfait l'ensemble des critères d'un dépôt idéal de catalyseur.

Dans l'article intitulé Electrochemical stability of citrate-capped gold nanoparticles electrostatically assembled on amine-modified glassy carbon, Electrochimica Acta, 54 (23), pp. 5566-5570, 2009, Cruickshank A.C. et al. décrivent le dépôt de nanoparticules d'or enrobées par du citrate et assemblées sur des films d'éthylènediamine électrogreffés à une surface de carbone vitreux.

Dans l'article intitulé Localized Attachment of Carbon Nanotubes in Microelectronic Structures, Adv. Mater., 21: 4404-4408, 2009, Joyeux X. *et al.* décrivent un procédé comprenant une étape d'électrogreffage d'un sel de diazonium à la surface d'un substrat de titane ou de silicium, suivie d'une étape d'immersion de la surface fonctionnalisée ainsi obtenue dans un mélange contenant des nanotubes de carbone. Le produit final présente des nanotubes liés au substrat par une série de liaisons covalentes.

L'objet de l'invention est de fournir un procédé de dépôt de nanoparticules, en particulier de nanoparticules de catalyseur, satisfaisant l'ensemble des critères recherchés.

En particulier, ce procédé permet le dépôt de nanoparticules, d'oxydes isolants tels que d'oxydes métalliques, ce qui permet la conservation de l'intégrité des nanoparticules à haute température.

Par "nanoparticules", on entend dans l'invention, des particules de diamètre moyen très faible, inférieur à 10 nm, de préférence compris entre 2 et 4 nm.

Ce procédé de dépôt de nanoparticules permet de plus de faire croître des nanotubes de carbone dans des structures de petites dimensions.

A cet effet, l'invention propose un procédé de dépôt de nanoparticules en un matériau conducteur ou semi-conducteur ou isolant sur des zones déterminées Z en un matériau conducteur ou semi-conducteur d'un substrat S, caractérisé en ce qu'il comprend les étapes suivantes :
a) création autour des zones Z, de zones I en un matériau isolant, lorsque ces zones I ne sont pas déjà présentes,
b) dépôt, par électrogreffage, sur le matériau conducteur ou semi-conducteur constituant les zones Z, d'un polymère P préparé à partir d'un sel de diazonium ou de sels de sulfonium ou de sels de diodonium ou de sels d'ammonium ou d'halogénures d'alkyle ou de monomères vinyliques ou d'un mélange de ceux-ci,
c) enrobage des nanoparticules avec un matériau d'enrobage comprenant une molécule bifonctionnelle apte à créer une liaison avec les nanoparticules et une liaison avec le polymère P,
d) mise en suspension des nanoparticules enrobées obtenues à l'étape c) dans un solvant, de préférence une solution du matériau d'enrobage utilisé à l'étape c),
e) immersion du substrat S obtenu à l'étape b) dans la suspension obtenue à l'étape d), et
f) élimination du polymère P.

Dans ce procédé, les étapes a) et b) peuvent être effectuées avant ou après les étapes c) et d).

Le polymère P, qui est localisé sur les zones d'intérêts Z, joue le rôle de "pôle d'attraction" pour les nanoparticules. Il n'y a pas de lien ou réaction chimique menant à des liaisons fortes entre le polymère P et les nanoparticules, les nanoparticules sont attirées vers le polymère, en particulier en raison de leur enrobage.

Lorsque la surface des zones Z est oxydée, il est nécessaire, avant de greffer le polymère P, c'est-à-dire avant l'étape b) d'éliminer cette couche d'oxyde de surface.

Bien entendu, l'élimination du polymère P s'effectue après avoir retiré le substrat S de la suspension de nanoparticules et éliminé le solvant de la suspension.

L'élimination du polymère P peut se faire par tous moyens. De préférence, elle s'effectue par décomposition thermique du polymère P.

Lors de cette élimination du polymère P, il n'y a pas de libération des nanoparticules car celles-ci sont soumises à des forces d'attraction de la part du substrat par des forces de type Van der Waals, en particulier.

Quant aux nanoparticules, elles sont de préférence choisies parmi des nanoparticules d'un métal ou d'un oxyde métallique.

Plus préférablement, dans le procédé de l'invention, les nanoparticules sont des nanoparticules d'oxyde de nickel ou d'oxyde de fer ou d'oxyde de cobalt ou des alliages ou mélanges de ceux-ci, tels que des oxydes de nickel et de cobalt, des oxydes de fer et de cobalt ou encore des oxydes de fer et de nickel.

Lorsque les nanoparticules ne sont pas oxydées, en particulier dans le cas de nanoparticules de métal, le procédé de l'invention comprend de plus, une étape d'oxydation partielle ou totale de leur surface.

Les nanoparticules sont formées par exemple par réduction de sels métalliques par des réducteurs doux, tel qu'un polyol, par l'hydrazine, par les borohydrures, par précipitation en milieu basique, par lithographie par faisceau d'électrons ou par tout autre méthode connue.

Une méthode préférée est la méthode de réduction par le polyol.

Cette méthode est décrite par Poul L. et al., dans "Synthesis of Inorganic Compounds (Metal, Oxide and Hydroxide) in Polyol Medium : A Versatile Route Related to the Sol-Gel Process", Journal of Sol-Gel Science and Technology 26, 261-265; 2003.

Ces nanoparticules une fois totalement oxydées ou partiellement oxydées, ou lorsqu'il s'agit de nanoparticules déjà oxydées, sont, dans le procédé de l'invention, mises en suspension dans un solvant pour procéder à leur dépôt sur les zones Z déterminées du substrat S.

Il est donc nécessaire de stabiliser les nanoparticules dans le solvant par un enrobage (capping).

Cet enrobage sert également à faire que les nanoparticules sont attirées par le polymère P.

Cet enrobage peut être effectué avec le solvant de la suspension.

Mais il peut encore résulter de l'ajout d'un matériau d'enrobage pendant la synthèse des nanoparticules.

Il peut encore être mis en oeuvre après la synthèse des nanoparticules.

De préférence, les nanoparticules sont enrobées dans le solvant utilisé pour leur mise en suspension. Dans ce cas, dans le procédé de l'invention, l'étape c) d'enrobage, et l'étape d) de mise en suspension seront simultanées.

Mais, l'enrobage, encore une fois, pourra être effectué après la synthèse des nanoparticules, avant leur mise en suspension dans un solvant qui sera alors différent du matériau d'enrobage.

Dans tous les cas, le matériau d'enrobage est de préférence choisi parmi le poly(hydroxyméthylméthacrylate), le diéthylène glycol, et le bromure de céthyltriméthylammonium.

Le substrat S peut être entièrement en un matériau conducteur ou semi-conducteur, auquel cas il est nécessaire de créer, autour des zones Z sur lesquelles on veut déposer les nanoparticules, des zones I en un matériau isolant.

Mais le substrat peut également déjà naturellement comporter des zones Z en matériau conducteur ou semi-conducteur et des zones en un matériau isolant, auquel cas, ils n'est pas nécessaire de créer des zones I, celles-ci existant déjà.

Le matériau conducteur ou semi-conducteur est plus particulièrement, dans l'invention, un matériau choisi parmi du carbone, du silicium dopé ou non, un siliciure, un métal.

Du siliciure de nickel ou de fer ou de cobalt peut être utilisé.

Un métal préféré est l'aluminium ou le titane.

Le matériau conducteur ou semi-conducteur peut également être du nitrure de titane (TiN) ou du nitrure de tantale (TaN).

Les zones I en un matériau isolant sont de préférence en un matériau choisi parmi la silice (SiO₂), l'alumine (Al₂O₃), et un verre de phosphosilicate (PSG).

Les zones I en un matériau isolant doivent avoir le minimum d'interactions possibles avec le matériau d'enrobage des nanoparticules.

Ainsi, lorsque les zones I sont en silice, qui est hydrophile, et que le matériau d'enrobage possède une fonction hydrophile dirigée vers l'extérieur de la nanoparticule, il est nécessaire de transformer la surface de la silice auquel se sont liés des groupements OH en une surface du type SiH hydrophobe ou une surface silanisée, obtenue par exemple par traitement de cette surface avec un silane qui réagit avec les groupes OH de la surface et qui possède des groupes hydrophobes à l'extérieur de la couche.

D'autre part, la couche d'oxyde éventuellement formée à la surface des zones Z en un matériau conducteur ou semi-conducteur du substrat S, doit être enlevée pour assurer une bonne conduction.

Dans le cas d'un matériau semi-conducteur tel que le silicium, le silicium dopé ou un siliciure, cette étape d'élimination de la couche d'oxyde de surface peut être effectuée avec une solution d'acide fluorhydrique : par exemple, le substrat S est immergé dans une solution d'acide fluorhydrique à 0,2 % en volume dans l'eau pendant 2 minutes sous ultrasons.

L'échantillon est ensuite rincé à l'eau distillée et séché à l'argon.

Dans le cas de zones Z en un matériau conducteur tel que le titane ou le nitrure de titane, l'étape d'élimination de la couche d'oxyde de surface est effectuée dans une solution d'acide sulfurique : par exemple, le substrat S est immergé dans une solution d'acide sulfurique à 10% en volume dans l'eau pendant 5 minutes. L'échantillon est ensuite rincé à l'eau distillé et séché à l'argon.

Bien entendu, l'élimination de la couche d'oxyde de surface du matériau conducteur ou semi-conducteur peut être effectuée par d'autres méthodes comme cela apparaîtra clairement à l'homme de l'art.

Mais, le coeur de l'invention réside dans l'étape de dépôt, sur les zones Z, d'une couche d'un polymère P qui joue le rôle de couche d'imprégnation permettant de capter les nanoparticules en suspension.

Le dépôt de cette couche d'imprégnation, c'est-à-dire de la couche du polymère P est effectué, dans le procédé de l'invention, par électrochimie, plus précisément par électrogreffage, sur les zones Z, ce qui assure la sélectivité de ce dépôt sur les zones conductrices.

Ainsi, on voit que grâce au procédé de l'invention, on allie la souplesse de la chimie pour réaliser et sélectionner le diamètre et l'écart type de la distribution des particules à déposer à la sélectivité de l'électrochimie pour former des couches de polymères localisées sur les zones Z.

De plus, comme le dépôt des nanoparticules ne se fait pas par électrochimie, le dépôt de particules isolantes comme les oxydes métalliques est possible, ce qui est un grand avantage pour maintenir l'individualité de chaque nanoparticule, jusqu'à la température de croissance des nanotubes de carbone, lorsqu'on veut ensuite faire croître des nanotubes de carbone.

Ce polymère P doit ainsi être susceptible d'être électrogreffé sur le matériau conducteur ou semi-conducteur constituant les zones Z. Des polymères adaptés dans ce but sont les polymères préparés à partir d'un sel de diazonium ou de monomères vinyliques ou de mélange de ceux-ci.

Il peut donc s'agir d'un polymère P qui comprend des fonctions ammonium, amine, alcool, carboxylate, carboxylique, halogénure, thiol et les mélanges de ceux-ci.

Par électrogreffage, on entend dans l'invention, l'ensemble des méthodes qui permettent d'établir les liaisons suffisamment fortes entre un métal, un matériau semi-conducteur, le carbone ou même une surface oxydée, et un polymère par transfert d'électrons par exemple, par l'intermédiaire d'une réaction électrochimique.

Ces méthodes peuvent être classées dans deux catégories, les méthodes par oxydation et les méthodes par réduction.

Les méthodes par oxydation procèdent par l'oxydation de fonctions amines, d'alcools, de carboxylates, de réactifs de Grignard (organomagnésiens).

Les méthodes par réduction utilisent la réduction de sels d'aryl diazoniums, de composés vinyliques, de mélanges de composés comprenant des fonctions diazoniums et vinyliques et également des halogénures d'alkyles, des sels d'ammonium, de sulfonium, d'iodonium....

Lorsque le polymère P est préparé à partir d'un sel de diazonium, il comprend alors des motifs de répétition de type aryle de formule suivante : 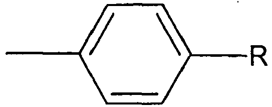 dans laquelle R est un alkyle en C₁ à C₁₄, ou une chaîne alkyle partiellement ou totalement substituée par des halogènes, CN, OH, NH₂, NO₂, COOH, ou un aryle en C₆ ou un aryle condensé en d₁₀, tel que le naphtalène, ou en C₁₄, tel que l'anthracène, ou CN, OH, NH₂, NO₂, COOH, ou encore une protéine.

L'électro-neutralité est assurée par un anion, par exemple un halogène (X⁻) ou un fluoroborate BF₄.

La réaction qui se produit est la suivante :

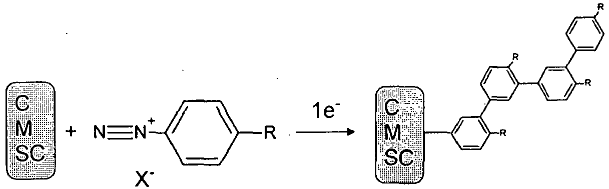

Lorsque le polymère P est préparé à partir de monomères vinyliques, il comprend alors des motifs de formule suivante : 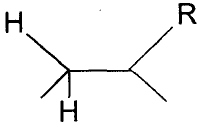 dans laquelle R est un alkyle en C₁ à C₁₄, ou une chaîne alkyle partiellement ou totalement substituée par des halogènes, CN, OH, NH₂, NO₂, COOH, ou un aryle en C₆, ou un aryle condensé en C₁₀, tel que le naphtalène, ou en C₁₄, tel que l'anthracène, ou CN, OH, NH₂, NO₂, COOH, ou encore une protéine.

Dans ce cas, le polymère P est un polymère poly(acrylonitrile), ou poly(butène nitrile), ou poly(méthacrylonitrile), ou poly(méthacrylate), ou poly(hydroxyéthylméthacrylate), ou poly(hydroxyméthylméthacrylate), ou un polystyrène de préférence.

Dans ce cas l'électrogreffage du polymère P à la surface conductrice se produit de la façon suivante sur les zones Z du substrat :

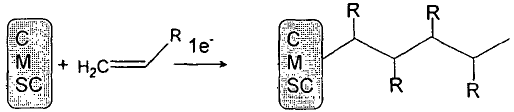

Lorsque le polymère P est obtenu à partir d'un de sel de diazonium et de monomères vinyliques, la réaction d'électrogreffage de ces polymères sur les zones Z du substrat S se produit selon le schéma suivant dans les solvants protiques ou aprotiques :

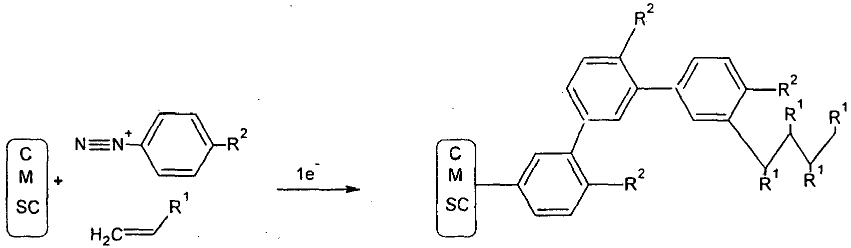

Dans les schémas qui précèdent, C désigne du carbone, M un métal, SC un matériau semi-conducteur et représentent les matériaux dont sont constituées les zones Z et R₁ et R₂ sont identiques ou différents et ont individuellement les mêmes significations que définies préalablement pour le groupement R.

Un polymère P préféré est un poly(4-carboxyphénylène) obtenu à partir du sel diazonium correspondant (4-carboxy-benzène diazonium).

De préférence, dans le procédé de l'invention, les zones Z du substrat S sont les fonds de vias d'électrode.

Une fois le substrat S préparé de la façon qui précède, c'est-à-dire sur lequel on a greffé, sur les zones Z, le polymère P, il est immergé dans la suspension de nanoparticules pendant un temps déterminé et une température de bain contrôlée. Ce temps et cette température seront facilement déterminés par l'homme de l'art, par de simples expérimentations.

Le temps et la température permettent de contrôler la densité de nanoparticules déposées sur les zones Z en matériau conducteur ou semi-conducteur.

C'est l'ensemble des interactions physiques ou chimiques entre l'enrobage des nanoparticules et le polymère P électrogreffé en même temps que l'absence, autant que possible, d'interactions entre l'enrobage des nanoparticules et les zones I en un matériau isolant qui assure la sélectivité du dépôt.

Cette sélectivité peut être de type thermodynamique, c'est-à-dire que les interactions entre l'enrobage de nanoparticules et le polymère P électrogreffé peuvent être plus fortes (ΔG<0) qu'entre l'enrobage de la nanoparticule et les zones I en un matériau isolant.

Mais elle peut aussi être de type cinétique, c'est-à-dire que l'interaction entre l'enrobage de la nanoparticule et le polymère P électrogreffé s'établira plus vite qu'avec les zones I en un matériau isolant.

L'homme de l'art déterminera par des essais de temps variables, à quel moment arrêter le dépôt.

L'invention propose également un procédé de fabrication de nanotubes de carbone.

En effet, une fois les nanoparticules déposées, sur des zones Z déterminées du substrat, ces zones Z étant de préférence les fonds de vias d'électrode, et ce après élimination du polymère P, les nanotubes peuvent être mis à croître sur les nanoparticules déposées, par exemple en phase vapeur.

Dans ce cas, le procédé de croissance comporte une étape d'oxydation des nanoparticules. A cet effet, une étape de mise en température du substrat sous une atmosphère d'oxygène est mise en oeuvre, contrairement à ce qui se fait classiquement.

En effet, généralement, la première étape de la croissance de nanotubes de carbone est une étape de réduction des nanoparticules de catalyseur.

Dans le procédé de fabrication de nanotubes de carbone de l'invention, l'étape d'oxydation permet d'éviter, en particulier, la coalescence des nanoparticules lors de la montée en température du dispositif pour la croissance des nanotubes. Cette étape d'oxydation est une étape d'oxydation partielle (en surface) des nanoparticules ou d'oxydation complète (à coeur) de la nanoparticule.

Ainsi, le substrat S obtenu par le procédé de l'invention est placé dans une enceinte de chauffage sous une pression partielle d'oxygène ou d'air de 0,3 mbar jusqu'à une température de 600°C.

Puis, un mélange réactif composé de 50sccm d'hélium, 50sccm d'hydrogène et 10sccm d'acétylène est alors introduit en l'enceinte, sous une pression de 1 torr.

On laisse alors la croissance s'effectuer, jusqu'à obtention de la taille (longueur) voulue des nanotubes compris entre 1 à 100 µm, inclus, généralement pendant 5 à 10min.

L'enceinte de chauffage est ensuite refroidie sous un flux d'hélium.

Mais le procédé de dépôt de nanoparticules de l'invention peut également être utilisé pour déposer des nanoparticules magnétiques sur des structures bidimensionnelles.

Ces nanoparticules sont en particulier en un oxyde de fer paramagnétique.

Le procédé de dépôt de nanoparticules de l'invention peut également être utilisé pour déposer des particules de silice en photoluminescence.

Dans le procédé de dépôt de l'invention, l'enrobage des nanoparticules doit être complet de façon à ce que la surface oxydée de la nanoparticule ne soit pas susceptible d'une interaction ni avec les zones Z du substrat sur lesquelles le polymère P est électrogreffé, ni avec les zones I.

Ce sont les interactions entre le matériau d'enrobage de la nanoparticule et le polymère P électrogreffé qui assurent la spécificité du dépôt des nanoparticules sur les zones Z conductrices ou semi-conductrices du substrat.

Ces interactions peuvent être de trois types :
- forces de Van der Waals,
- liaisons hydrogènes, ,
- interactions électrostatiques.

D'autre part, les interactions entre le matériau d'enrobage des nanoparticules et les zones I en matériau isolant du substrat doivent être les plus faibles possibles ; le plus souvent le matériau isolant est constitué de silice SiO₂, hydrophile, portant des groupes OH.

Mais comme on l'a déjà dit, il est possible par des traitements par HF ou NH₄F, bien connus dans l'industrie de la microélectronique de transformer la surface de la silice en une surface hydrogénée, SiH hydrophobe.

Avec le procédé de l'invention il est donc possible, ce qui est important, de moduler à la fois la réactivité de la couche de polymère P électrogreffé et des zones I en un matériau isolant avec le matériau d'enrobage des nanoparticules.

L'invention propose encore un procédé de fabrication d'une électrode de pile à combustible qui comprend une étape de fabrication de nanoparticules selon le procédé de l'invention.

Dans le cas où l'on veut obtenir la croissance de nanotubes de carbone dans cette électrode, l'invention propose enfin un procédé de fabrication d'une électrode qui comprend une étape de fabrication de nanotubes de carbone selon l'invention, c'est-à-dire comprenant une étape de dépôt de nanoparticules dans des vias de l'électrode, selon le procédé de l'invention et une étape de croissance des nanotubes de carbone en phase vapeur à partir de ces nanoparticules, qui dans ce cas sont des nanoparticules de catalyseur.

Afin de mieux comprendre l'invention, on va en décrire maintenant plusieurs exemples de mise en oeuvre.

Ces exemples sont donnés à titre purement illustratifs et non limitatifs.

### Exemple 1 : Interactions par liaisons hydrogènes

### Les nanoparticules d'oxyde de fer sont enrobées de diéthylène glycol (DEG)/couche électrogreffée de polyhydroxyéthyl méthacrylate (p HEMA).

Dans cet exemple on utilise un substrat en silicium recouvert de silice, dans lequel ont été gravés des vias jusqu'au silicium.

Le fond des vias est constitué de silicium, de titane ou d'aluminium.

Les nanoparticules sont préparées par la méthode polyol décrite par Poul L. et al., "Synthesis of Inorganic Compounds (Metal, Oxide and Hydroxide) in Polyol Medium : A Versatile Route Related to the Sol-Gel Process", Journal of Sol-Gel Science and Technology 26, 261-265, 2003.

### Préparation des nanoparticules enrobées de DEG.

Une quantité appropriée d'acétate de fer (II) est ajoutée à un volume donné (125 mL) de DEG jusqu'à atteindre une concentration nominale de cations de fer de 0.2 M. De l'eau déionisée est ajoutée jusqu'à atteindre un ratio d'hydrolyse, défini par le ratio molaire eau/fer, de ~11. Le mélange est alors mis à chauffer à une vitesse de 6 °C.min⁻¹ sous agitation jusqu'au point d'ébullition et maintenu à cette température pendant 2 heures. La poudre marron obtenue est lavée plusieurs fois avec de l'éthanol puis de l'acétone sous ultrasons avec une centrifugation intermittente et séchée à l'air à 50 °C.

### Préparation du substrat

La première étape de la préparation du substrat à l'électrogreffage est le nettoyage.

Lorsque le fond des vias est en silicium, elle consiste à enlever la couche d'oxyde SiO₂ natif sur le silicium au fond des vias, et transformer la surface de SiO₂ en SiH. Cette étape doit s'effectuer sans dégrader la structure en SiO₂. On utilise pour cela une solution d'acide fluorhydrique (HF) diluée : 0.2 %. Plus précisément, le substrat est immergé dans la solution d'HF pendant 2 minutes sous ultrasons. L'utilisation de la sonication est justifiée par le renouvellement des molécules d'HF sur la surface du silicium au fond des vias. Le temps très court de nettoyage permet de ne pas endommager les parois des vias en Si02. Le substrat est ensuite abondamment rincé à l'eau DI et est utilisé rapidement pour l'électrogreffage.

On procède de même pour des vias dont le fond est constitué de titane pour éliminer la couche d'oxyde de titane formée sur le titane.

### Préparation d'une couche de p-HEMA sur le silicium, le titane ou l'aluminium.

Le protocole expérimental standard utilisé est décrit dans la demande de brevet US2007/0209943.

En pratique, 20 10⁻³ mol de monomère (HEMA) sont dissous dans 50 mL d'HCl 1.2 M, puis la solution est versée dans une cellule électrochimique et dégazée à l'argon. Après une demi-heure, 5 10⁻⁴ mol de diazonium sont dispersés dans la solution. Le substrat est alors connecté en face arrière via un contact à la colle d'argent et placé dans la cellule en face d'une contre-électrode en feuille de carbone. Une électrode de référence au calomel saturée (SCE) est ajoutée. Le potentiel est appliqué entre le potentiel d'équilibre de la solution en circuit ouvert et -2 V/SCE. Huit balayages sont effectués afin d'obtenir une épaisseur de couche de polymère d'environ 15 nm. L'échantillon est ensuite rincé à la pissette au diméthylformamide (DMF) pour éliminer les traces de polymère non greffé, à l'acétone pour éliminer le DMF et finalement à l'eau pour éliminer toutes traces d'organiques. Après séchage à l'argon, l'échantillon est prêt pour le dépôt de nanoparticules.

### Dépôt des nanoparticules enrobées sur le polymère électrogreffé

0,4 mg de nanoparticules sont mises en suspension dans 5 mL de DEG, ce qui représente 0,08 g/L de nanoparticules en suspension. Après sonication pendant une heure à 50°C, les suspensions de nanoparticules ont été centrifugées à 10000 rpm pendant 10 min et seul le surnageant de ces suspensions a été déposé sur des substrats incluant les vias à fond Si électrogreffé par le polymère pHEMA pendant 15 minutes. L'augmentation de la température permet de rendre le solvant moins visqueux et donc de faciliter le mouvement des particules jusqu'au fond des vias. Le DEG a une viscosité de 30.200 cp à 25°C. Celle-ci descend à 2.505 à 100°C.

La mobilité des nanoparticules en solution se trouve donc améliorée. De plus la température de transition vitreuse (Tg) du p-HEMA est de 87°C, en conséquence les chaines de polymère peuvent bouger plus facilement à une température supérieure à Tg. Une élévation de température favorise donc l'adsorption de nanoparticules sur le polymère.

On obtient par ce procédé une densité de nanoparticules de ~10¹² Nanoparticule/cm² bien dispersées.

### Recuit

Le polymère permettant l'adsorption des nanoparticules doit être détruit par recuit avant de procéder à une croissance des nanotubes de carbone (CNTs). Des échantillons comportant des nanoparticules dans leurs fonds de vias ont subit un recuit sous air à 450°C (ou supérieur à la température de décomposition du polymère).

Dans cet exemple la sélectivité du greffage sur les zones Z voulue est assurée par la similitude entre les structures du DEG:
HO-CH₂-CH₂-**O-CH₂-CH₂-OH**
et du p-HEMA: {-CH₂-CH-(CH₃)[C(=O)-**O-CH₂-CH₂OH]**-}ₙ

Ce sont les forces de Van der Waals entre les CH₂ et les surtout les liaisons hydrogènes entre les OH qui assurent l'essentiel de la sélectivité, l'autre partie de la sélectivité est obtenue par la faible affinité la surface de SiO₂ traitée par HF et le DEG. La meilleure preuve est la suivante : lorsqu'on utilise le diéthylèneglycol diméthyléther CH₃O-CH₂-CH₂-O-CH₂-CH₂-OCH₃ où, les groupes OH sont méthylés, les liaisons hydrogènes ne sont plus possibles, les nanoparticules se dispersent sur l'ensemble de la structure.

### Exemple 2 : Interactions par liaisons hydrogènes

### Nanoparticules d'oxyde de_fer et de cobalt enrobées de diéthylène glycol (DEG)/couche électrogreffée de poly-hydroxyéthylméthacrylate (p HEMA).

Dans cet exemple on utilise le même substrat qu'à l'exemple 1 et des nanoparticules de fer et de cobalt CoFe₂O₄ synthétisées dans le diéthylène glycol.

### Préparation des nanoparticules enrobées de DEG

Les sels précurseurs, FeCl₃ et Co(CH₃COOH)₂.4H₂O en proportion stoechiométrique (2:1) sont ajoutés à un volume de 1,2-propanediol donné (250 mL).

La concentration totale de métal est 0.3 mol L⁻¹. L'ajout d'eau et d'acétate de sodium permet de mieux contrôler la taille des nanoparticules. Pour l'obtention de nanoparticules ayant un diamètre moyen de 5,5 nm, il est nécessaire d'avoir des ratio nₑₐᵤ/n_{métal} et n_{NaCOO}/n_{métal} de 9 et 3 respectivement. On introduit donc 8,11 g de FeCl₃, 6,23 g de Co(CH₃COOH)₂.₄H₂O et 18,45 g de carbonate de sodium dans une solution de 250 mL de 1,2-propanediol et 12,15 mL d'eau. Le mélange est chauffé jusqu'au point d'ébullition (160°C) avec une vitesse de montée en température de 6 °C min⁻¹. La phase ferrite est formée via un procédé chimique impliquant la formation d'une phase intermédiaire. En conséquence, le mélange doit être mis sous reflux pendant 5 heures pour obtenir le produit final comme une phase solide pure.

Après refroidissement à température ambiante, les particules sont séparées depuis le surnageant par centrifugation, lavées à l'éthylène glycol et acétone, puis séchées à l'air à 50 °C. Les nanoparticules séchées sont ensuite dispersées dans le DEG pendant une heure sous ultrasons. Le matériau d'enrobage 1,2-propanediol est donc échangé par du DEG. Cette dispersion de nanoparticules est utilisée par la suite.

### La suite des opérations est la même que dans l'exemple 1.

### Exemple 3 : Interactions de Van der Waals

### Nanoparticules d'oxyde de fer enrobées de poly méthylméthacrylate/couche électrogreffée de poly méthylméthacrylate.

Le substrat est identique à celui de l'exemple 1.

### Préparation des nanoparticules enrobées de poly(méthylméthacrylate).

A une solution de FeCl₂ (7,1 mM) et de poly(méthylméthacrylate) (5% en poids) dans du tétrahydrofurane (THF) (50 mL) on ajoute goutte à goutte un mélange de Superhydrure -THF et 50 mL de THF. On laisse réagir pendant une heure puis une heure supplémentaire en présence d'air pour assurer l'oxydation des nanoparticules. Les nanoparticules stabilisées par le PMMA sont précipitée à l'éthanol et redissoutes dans le THF plusieurs fois pour éliminer les sous-produits de la réaction. Les nanoparticules forment alors une suspension dans le THF.

### Préparation de l'échantillon.

Aucun nettoyage n'est effectué pour ne pas hydrogéner la silice. Elle reste donc hydrophile.

### Préparation d'une couche de p-MMA (poly-méthylméthacrylate) sur le silicium.

Une solution contenant 10 mM de 4-nitrobenzènediazonium, 50% en volume de méthylméthacrylate et 10 mM de nitrate de sodium est préparée dans du DMF, dans une cellule électrochimique telle que celle de l'exemple 1, on effectue 2 cycles entre le potentiel de circuit ouvert et-2.8V/SCE à une vitesse de balayage de 100 mVs⁻¹. La structure est ensuite rincée sous ultrasons dans le DMF, puis l'eau désionisée et séchée. On obtient une couche d'environ 20 nm de poly(méthylméthacrylate).

### Dépôt des nanoparticules enrobées sur le polymère électrogreffé

La structure obtenue est immergée dans la solution de nanoparticules enrobées de p-MMA dans le THF, on laisse les nanoparticules réagir pendant 10 minutes, puis on rince au THF, au DMF et enfin à l'eau désionisée.

### Recuit

Des échantillons comportant des nanoparticules dans leurs fonds de trous de via ont subit un recuit sous air à 450°C.

Dans cet exemple, le même polymère enrobe les nanoparticules et recouvre la surface du silicium. Ce sont les interactions entre les chaînes de p-MMA sur les nanoparticules et la couche électrogreffée qui assurent la spécificité.

D'autre part, les groupes -CH₂-C(CH₃), hydrophobes du p-MMA sont à l'extérieur de l'enrobage, ils n'ont aucune affinité pour la surface hydrophile de la silice.

### Exemple 4 : Interactions électrostatiques

### Nanoparticules d'oxyde de nickel enrobées de cétyl triméthylammonium bromure (CTAB)/couche électrogreffée de poly(acrylate) (p acryCOO⁻).

Dans cet exemple, on utilise un substrat en silicium identique à celui de l'exemple 1.

Des nanoparticules de nickel ou d'argent peuvent être préparées par réduction de sels de nickel par l'hydrate d'hydrazine en solution aqueuse et en présence de CTAB (bromure de cétyltriméthyl ammonium) ; on obtient des nanoparticules monodispersées (20 nm et 13 nm, respectivement) de Ni/Ni(OH)₂ qui perdent leur couche de CTAB vers 300°C. Elles ont été étudiées par diverses techniques: spectroscopie UV-visible, FTIR, RMN, TGA, diffraction des rayons X à petit angle. La présence d'une bicouche de cétyl triméthylammonium sur la surface de ces nanoparticules est clairement montrée : une image de cette bicouche a été obtenue par des calculs de mécanique moléculaire qui traduit les mesures spectroscopiques et montre des groupes polaires -N+ tournées vers le solvant.

Le même type d'enrobage a été mis en évidence sur des nanoparticules de cuivre, des nanobâtonnets d'or, sur des nanoparticules d'or préparées dans les mêmes conditions.

### Préparation des nanoparticules d'oxyde de nickel enrobées de cétyltriméthylammonium bromure.

Les nanoparticules de nickel sont préparées. 1 g de CTAB (3 10⁻³ mol) sont versés dans 50 mL d'eau en chauffant légèrement jusqu'à dissolution totale. 250 mg de NiSO₄ (10⁻³ mol) sont ensuite ajoutés au mélange et 100 mg de NaBH₄ (2.6 10⁻³ mol) sont versés rapidement. Après 5 minutes de réaction, les échantillons peuvent être immergés dans ce mélange de nanoparticules.

### Préparation de l'échantillon

Les surfaces sont traitées comme dans l'exemple 1 pour transformer la surface de silice formée sur le silicium en SiH.

### Préparation d'une couche de poly acrylate sur le silicium, le titane ou l'aluminium.

Le protocole expérimental standard est défini comme suit : 20 10⁻³ mol de monomère (acide acrylique) sont dissous dans 50 mL d'HCl à 1.2 M, puis la solution est versée dans une cellule électrochimique et dégazée à l'argon. Après une demi-heure, 5 10⁻⁴ mol de diazonium sont dissous dans la solution. Le substrat est alors connecté en face arrière via un contact à la colle d'argent et placé dans la cellule en face d'une contre-électrode en feuille de carbone. Une électrode de référence au calomel saturée (SCE) est ajoutée. Le potentiel est appliqué entre le potentiel d'équilibre de la solution en circuit ouvert et -2 V/SCE à une vitesse de balayage de 100 mVs⁻¹. Deux balayages sont effectués afin d'obtenir une épaisseur de couche de polymère d'environ 15 nm. L'échantillon est ensuite rincé à la pissette au DMF pour éliminer les traces de polymère non greffé, à l'acétone pour éliminer le DMF et finalement avec une solution saturée de bicarbonate pour neutraliser les fonctions carboxylates (-COO⁻). Après séchage à l'argon, l'échantillon est prêt pour le dépôt de nanoparticules.

### Dépôt des nanoparticules enrobées sur le polymère électrogreffé

La structure, où le silicium a été préalablement électrogreffé par l'acide acrylique neutralisé, c'est-à-dire sous forme acrylate, est immergée dans la dispersion de nanoparticules à 110 °C (Tg de l'acide poly acrylique). On observe par microscopie électronique des nanoparticules bien dispersées sur le polymère d'environ 12 nm d'épaisseur.

### Recuit

### Comme à l'exemple 1.

Dans cet exemple, la spécificité du greffage sur les zones Z voulues est assurée essentiellement par l'interaction électrostatique entre les groupes carboxylates COO⁻ de l'acide acrylique et les groupes ammoniums du CTAB-N⁺(CH₃)₃ à l'extérieur de la double couche de CTAB servant d'enrobage, et l'absence d'interactions entre la silice hydrogénée et l'enrobant.

Si---**COO**^{- +}N(CH₃)₃ (CH₂)₁₅CH₃ CH₃(CH₂)₁₅ (CH₃)₃N⁺Niox NP.

### Exemple 5. Interactions électrostatiques

### Nanoparticules d'oxyde de nickel enrobées de cétyl triméthylammonium bromure (CTAB)/couche électrogreffée de poly(4-carboxyphénylène).

On procède comme à l'exemple 4, mais l'acide poly-acrylique est remplacé par du poly 4-carboxyphénylène obtenu par réduction électrochimique du sel de diazonium de l'acide 4-aminobenzoïque.

### Préparation d'une couche de poly 4-carboxyphénylène sur le silicium ou le titane.

On prépare une solution 10 mM d'acide 4-aminobenzoïque, dans une solution d'acide chlorhydrique à pH 2, on refroidit la solution vers 5°C, on ajoute ensuite une concentration de 11 mM de NaNO2. Cette solution est versée dans une cellule électrochimique semblable à celle de l'exemple 1 et on maintient le potentiel (chronoampérométrie) pendant 300s à -0.5 V/SCE pour obtenir une couche d'environ 20nm. Cette couche est soigneusement rincée sous ultrasons dans l'eau puis l'acétone, elle est ensuite traitée par une solution de carbonate de sodium pour déprotoner les groupes carboxyliques. Elle est utilisée comme la couche d'acide acrylique de l'exemple précédent.

## Revendications

1. Procédé de dépôt de nanoparticules en un matériau conducteur ou semi-conducteur ou isolant sur des zones déterminées Z en un matériau conducteur ou semi-conducteur d'un substrat S, **caractérisé en ce qu'**il comprend les étapes suivantes :
a) création autour des zones Z, de zones I en un matériau isolant, lorsque ces zones I ne sont pas déjà présentes,
b) dépôt, par électrogreffage, sur le matériau conducteur ou semi-conducteur constituant les zones Z, d'un polymère P préparé à partir de sel de diazonium, de sel d'ammonium, ou de sel de sulfonium, ou de sel de diodonium, ou d'halogénures d'alkyle, ou de monomères vinyliques, ou d'un mélange de ceux-ci,
c) enrobage des nanoparticules avec un matériau d'enrobage comprenant une molécule bifonctionnelle apte à créer une liaison avec les nanoparticules et une liaison avec le polymère P,
d) mise en suspension des nanoparticules enrobées obtenues à l'étape c) dans un solvant, de préférence une solution du matériau d'enrobage utilisé à l'étape c),
e) immersion du substrat S obtenu à l'étape b) dans la suspension obtenue à l'étape d), et
f) élimination du polymère P.

2. Procédé selon la revendication 1, **caractérisé en ce qu'**il comprend de plus, avant l'étape b) une étape d'élimination de la couche d'oxyde éventuellement formée sur la surface des zones Z.

3. Procédé selon la revendication 1 ou 2, **caractérisé en ce que** les nanoparticules ne sont pas oxydées en surface et **en ce qu'**il comprend de plus une étape d'oxydation partielle ou totale de la surface desdites nanoparticules, avant l'étape c) d'enrobage.

4. Procédé selon la revendication 1 ou 2, **caractérisé en ce que** les nanoparticules sont en un matériau choisi parmi un métal et un oxyde métallique.

5. Procédé selon la revendication 4, **caractérisé en ce que** les nanoparticules sont en un matériau choisi parmi l'oxyde de nickel, l'oxyde de fer, l'oxyde de cobalt et les mélanges et alliages de ceux-ci.

6. Procédé selon l'une quelconque des revendications précédentes, **caractérisé en ce que** le substrat S est en un matériau choisi parmi du carbone, du silicium dopé ou non, un siliciure, de préférence du siliciure de nickel, de fer ou de cobalt, un métal, de préférence l'aluminium, le titane, le nitrure de titane (TiN) et le nitrure de tantale (TaN).

7. Procédé selon l'une quelconque des revendications précédentes, **caractérisé en ce que** les zones I sont en un matériau choisi parmi la silice (SiO₂), l'alumine (Al₂O₃), et un verre de phosphosilicate.

8. Procédé selon l'une quelconque des revendications précédentes, **caractérisé en ce que** le polymère P comprend des fonctions ammonium, amine, alcool, carboxylate, carboxylique, halogénure, thiol et les mélanges de ceux-ci.

9. Procédé selon l'une quelconque des revendications précédentes, **caractérisé en ce que** le polymère P comprend un motif de répétition du type aryle de formule suivante : 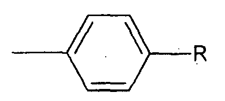 dans laquelle R est un alkyle en C₁ à C₁₄, ou une chaîne alkyle partiellement ou totalement substituée par des halogènes, CN, OH, NH₂, NO₂, COOH, ou un aryle en C₆, ou un aryle condensé en C₁₀, tel que le naphtalène, ou en C_{14,} tel que l'anthracène, ou CN, OH, NH₂, NO₂, COOH, ou encore une protéine.

10. Procédé selon l'une quelconque des revendications 1 à 8, **caractérisé en ce que** le polymère P est un polyvinyle comprenant des motifs de formule suivante : 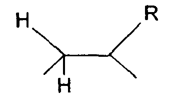 dans laquelle R est un alkyle en C₁ à C₁₄, ou une chaîne alkyle partiellement ou totalement substituée par des halogènes, CN, OH, NH₂, NO₂, COOH, ou un aryle en C₆, ou un aryle condensé en C₁₀, tel que le naphtalène, ou en C₁₄, tel que l'anthracène, ou CN, OH, NH₂, NO₂, COOH, ou encore une protéine.

11. Procédé selon la revendication 10, **caractérisé en ce que** le polymère P est un polymère poly(acrylonitrile), poly(butène nitrile), poly(méthacrylonitrile), poly(méthacrylate), poly(hydroxyalkyle en C₁ à C₁₄ méthacrylate), de préférence poly(hydroxyméthylméthacrylate) ou poly(hydroxyéthylméthacrylate) ou polystyrène.

12. Procédé selon l'une quelconque des revendications précédentes, **caractérisé en ce que** le matériau d'enrobage des nanoparticules est choisi parmi le poly(hydroxyméthylméthacrylate), le diéthylène glycol, et le céthylméthylammonium bromure.

13. Procédé selon l'une quelconque des revendications précédentes, **caractérisé en ce que** l'étape f) d'élimination du polymère P est une étape de décomposition thermique du polymère P.

14. Procédé selon l'une quelconque des revendications précédentes, **caractérisé en ce que** les zones Z sont les fonds de vias d'électrode.

15. Procédé de fabrication de nanotubes de carbone **caractérisé en ce qu'**il comprend une étape de dépôt de nanoparticules en un matériau conducteur, semi-conducteur ou isolant sur des zones déterminées Z d'un substrat S selon le procédé selon l'une quelconque des revendications 1 à 14 et une étape de croissance des nanotubes de carbone en phase vapeur à partir de ces nanoparticules.

16. Procédé de fabrication d'une électrode **caractérisé en ce qu'**il comprend une étape de dépôt de nanoparticules en un matériau conducteur, semi-conducteur, ou isolant selon l'une quelconque des revendications 1 à 14 ou une étape de fabrication de nanotubes de carbone selon la revendication 15.

## Patentansprüche

1. Verfahren zur Abscheidung von Nanopartikeln aus einem leitenden oder halbleitenden oder isolierenden Material auf bestimmten Zonen Z aus einem leitenden oder halbleitenden Material eines Substrats S, **dadurch gekennzeichnet, dass** es folgende Stufen umfasst:
a) Bildung um die Zonen Z herum von Zonen I aus einem isolierenden Material, wenn die Zonen I nicht schon vorhanden sind,
b) Abscheidung durch Elektrografting auf dem leitenden oder halbleitenden Material, das die Zonen Z bildet, von einem Polymer P, das hergestellt ist ausgehend von Diazoniumsalz, Ammoniumsalz oder Sulfoniumsalz oder Diodoniumsalz oder Alkylhalogeniden oder Vinylmonomeren oder Gemischen davon,
c) Umhüllung der Nanopartikel mit einem Umhüllungsmaterial, umfassend ein bifunktionelles Molekül, das in der Lage ist, eine Bindung mit den Nanopartikeln und eine Bindung mit dem Polymer P zu bilden,
d) das Suspendieren der in der Stufe c) erhaltenen umhüllten Nanopartikel in einem Lösungsmittel, bevorzugt einer Lösung des in der Stufe c) verwendeten Umhüllungsmaterials,
e) das Eintaüchen des in der Stufe b) erhaltenen Substrats S in die in der Stufe d) erhaltene Suspension und
f) Entfernung des Polymers P.

2. Verfahren nach Anspruch 1, **dadurch gekennzeichnet, dass** es des Weiteren, vor der Stufe b), eine Stufe der Entfernung der eventuell auf der Oberfläche der Zonen Z gebildeten Oxidschicht umfasst.

3. Verfahren nach Anspruch 1 oder 2, **dadurch gekennzeichnet, dass** die Nanopartikel nicht an der Oberfläche oxidiert sind und dass es des Weiteren eine Stufe der partiellen oder vollständigen Oxidation der Oberfläche der Nanopartikel vor der Stufe c) der Umhüllung umfasst.

4. Verfahren nach Anspruch 1 oder 2, **dadurch gekennzeichnet, dass** die Nanopartikel aus einem Material bestehen, das ausgewählt ist aus einem Metall und einem Metalloxid.

5. Verfahren nach Anspruch 4, **dadurch gekennzeichnet, dass** die Nanopartikel aus einem Material bestehen, das ausgewählt ist aus Nickeloxid, Eisenoxid, Cobaltoxid und den Gemischen und Legierungen davon.

6. Verfahren nach einem der voranstehenden Ansprüche, **dadurch gekennzeichnet, dass** das Substrat S aus einem Material besteht, das ausgewählt ist aus Kohlenstoff, dotiertem oder nicht-dotiertem Silicium, einem Silicid, bevorzugt Nickel-, Eisen- oder Cobaltsilicid, einem Metall, bevorzugt Aluminium, Titan, Titannitrid (TiN) und Tantalnitrid (TaN).

7. Verfahren nach einem der voranstehenden Ansprüche, **dadurch gekennzeichnet, dass** die Zonen I aus einem Material bestehen, das ausgewählt ist aus Siliciumdioxid (SiO₂), Aluminiumöxid (Al₂O₃) und Phosphosilicatglas.

8. Verfahren nach einem der voranstehenden Ansprüche, **dadurch gekennzeichnet, dass** das Polymer P Ammonium-, Amin-, Alkohol-, Carboxylat-, Carboxyl-, Halogenid-, Thiol-Funktionen und Gemische davon umfasst.

9. Verfahren nach einem der voranstehenden Ansprüche, **dadurch gekennzeichnet, dass** das Polymer P eine Repetiereinheit vom Aryltyp der folgenden Formel umfasst: 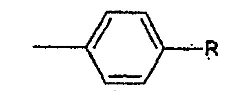 worin R für eine C₁-C₁₄-Alkylgruppe oder eine Alkylkette, die teilweise oder vollständig substituiert ist mit Halogenen, CN, OH, NH₂, NO₂, COOH, oder eine C₆-Arylgruppe oder eine kondensierte C₁₀-Arylgruppe steht, wie zum Beispiel Naphthyl, oder eine kondensierte C₁₄-Arylgruppe steht, wie zum Beispiel Anthracen, oder für CN, OH, NH₂, NO₂, COOH oder auch ein Protein steht.

10. Verfahren nach einem der Ansprüche 1 bis 8, **dadurch gekennzeichnet, dass** das Polymer P ein Polyvinyl ist, das Einheiten der folgenden Formel umfasst: 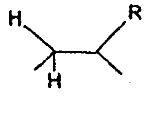 worin R für eine C₁-C₁₄-Alkylgruppe steht oder eine teilweise oder vollständig mit Halogenen, CN, OH, NH₂, NO₂, COOH substituierte Alkylkette steht oder eine C₆-Arylgruppe steht oder eine C₁₀-kondensierte Arylgruppe steht, wie zum Beispiel Naphthalin, oder für eine C₁₄-kondensierte Arylgruppe steht, wie zum Beispiel Anthracen, oder für CN, OH, NH₂, NO₂, COOH oder auch ein Protein steht.

11. Verfahren nach Anspruch 10, **dadurch gekennzeichnet, dass** das Polymer P ein Polymer Poly(acrylnitril), Poly(butennitril), Poly(methacrylnitril), Poly(methacrylat), Poly(C₁-C₁₄-hydroxyalkyl-methacrylat), vorzugsweise Poly(hydroxymethylmethacrylat) oder Poly(hydroxyethylmethacrylat) oder Polystyrol steht.

12. Verfahren nach einem der voranstehenden Ansprüche, **dadurch gekennzeichnet, dass** das Umhüllungsmaterial der Nanopartikel ausgewählt ist aus Polyhydroxymethylmethacrylat, Diethylenglykol und Cetylmethylammoniumbromid.

13. Verfahren nach einem der voranstehenden Ansprüche, **dadurch gekennzeichnet, dass** die Stufe f) der Entfernung des Polymers P eine Stufe der thermischen Zersetzung des Polymers P ist.

14. Verfahren nach einem der voranstehenden Ansprüche, **dadurch gekennzeichnet, dass** die Zonen Z die Böden von Elektrodenvias sind.

15. Verfahren zur Herstellung von Nanoröhren aus Kohlenstoff, **dadurch gekennzeichnet, dass** es eine Stufe der Abscheidung von Nanopartikeln aus einem leitenden, halbleitenden oder isolierenden Material auf bestimmten Zonen Z eines Substrats S durch das Verfahren nach einem der Ansprüche 1 bis 14 und eine Stufe des Wachsenlassens der Nanoröhren aus Kohlenstoff in der Dampfphase ausgehend von den Nanopartikeln umfasst.

16. Verfahren zur Herstellung einer Elektrode, **dadurch gekennzeichnet, dass** es eine Stufe der Abscheidung von Nanopartikeln aus einem leitenden, halbleitenden oder isolierenden Material nach einem der Ansprüche 1 bis 14 oder eine Stufe der Herstellung von Nanoröhren aus Kohlenstoff nach Anspruch 15 umfasst.

## Claims

1. Method of depositing nanoparticles made from a conductor or semiconductor or insulating material on selected zones Z made from a conductor or semiconductor material of a substrate S, **characterised in that** it comprises the following steps:
a) creating zones I made from an insulating material around the zones Z if these zones I are not already present,
b) depositing a polymer P prepared from diazonium salt, ammonium salt, or sulphonium salt, or diodonium salt, or alkyl halides, or vinyl monomers or a mixture thereof on the conductor or semiconductor material constituting the zones Z by electro-grafting,
c) coating the nanoparticles with a coating material comprising a bi-functional molecule capable of creating a bond with the nanoparticles and a bond with the polymer P,
d) suspending the coated nanoparticles obtained in step c) in a solvent, preferably a solution of the coating material used in step c),
e) immersing the substrate S obtained in step b) in the suspension obtained in step d), and
f) removing the polymer P.

2. Method as claimed in claim 1, **characterised in that** it further comprises, prior to step b), a step of removing the oxide layer which may have formed on the surface of the zones Z.

3. Method as claimed in claim 1 or 2, **characterised in that** the surface of the nanoparticles is not oxidised and it further comprises a step of partially or totally oxidising the surface of said nanoparticles prior to the coating step c).

4. Method as claimed in claim 1 or 2, **characterised in that** the nanoparticles are made from a material selected from a metal and a metal oxide.

5. Method as claimed in claim 4, **characterised in that** the nanoparticles are made from a material selected from nickel oxide, iron oxide, cobalt oxide and mixtures and alloys thereof.

6. Method as claimed in any one of the preceding claims, **characterised in that** the substrate S is made from a material selected from carbon, silicon which may or may not be doped, a silicide, preferably nickel, iron or cobalt silicide, a metal, preferably aluminium, titanium, titanium nitride (TiN) and tantalum nitride (TaN).

7. Method as claimed in any one of the preceding claims, **characterised in that** the zones I are made from a material selected from silica (SiO₂), alumina (Al₂O₃) and a phospho-silicate glass.

8. Method as claimed in any one of the preceding claims, **characterised in that** the polymer P comprises ammonium, amine, alcohol, carboxylate, carboxylic, halide and thiol functions and mixtures thereof.

9. Method as claimed in any one of the preceding claims, **characterised in that** the polymer P comprises a repeat unit of the aryl type based on the following formula: 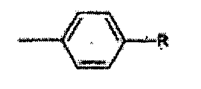 in which R is a C₁ to C₁₄ alkyl, or an alkyl chain partially or totally substituted by halogens, CN, OH, NH₂, NO₂, COOH, or a C₆ aryl, or a condensed C₁₀ aryl such as naphthalene, or a C₁₄ aryl such as anthracene, or CN, OH, NH₂, NO₂, COOH, or alternatively a protein.

10. Method as claimed in any one of claims 1 to 8, **characterised in that** the polymer P is a polyvinyl comprising units of the following formula: 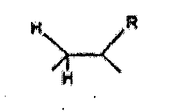 in which R is a C₁ to C₁₄ alkyl, or an alkyl chain partially or totally substituted by halogens, CN, OH, NH₂, NO₂, COOH, or a C₆ aryl, or a condensed C₁₀ aryl such as naphthalene, or a C₁₄ aryl such as anthracene, or CN, OH, NH₂, NO₂, COOH, or alternatively a protein.

11. Method as claimed in claim 10, **characterised in that** the polymer P is a poly(acrylonitrile), poly(butene nitrile), poly(methacrylonitrile), poly(methacrylate), poly(C₁ to C₁₄ hydroxyalkyl methacrylate), preferably poly(hydroxymethyl methacrylate) or poly(hydroxyethyl methacrylate) or polystyrene polymer.

12. Method as claimed in any one of the preceding claims, **characterised in that** the coating material of the nanoparticles is selected from poly(hydroxymethyl methacrylate), diethylene glycol and cetylmethyl ammonium bromide.

13. Method as claimed in any one of the preceding claims, **characterised in that** step f) of removing the polymer P is a step of thermal decomposition of the polymer P.

14. Method as claimed in any one of the preceding claims, **characterised in that** the zones Z are the bottoms of electrode vias.

15. Method of manufacturing carbon nanotubes, **characterised in that** it comprises a step of depositing nanoparticles made from conductor, semiconductor or insulating material on selected zones Z of a substrate S by means of the method as claimed in any one of claims 1 to 14, and a step of growing carbon nanotubes in vapour phase from these nanoparticles.

16. Method of manufacturing an electrode, **characterised in that** it comprises a step of depositing nanoparticles made from a conductor, semiconductor or insulating material as claimed in any one of claims 1 to 14 or a step of manufacturing carbon nanotubes as claimed in claim 15.
